# EUROPEAN PATENT APPLICATION

(11) **EP 4 779 832 A1**
(43) Date of publication of application: **22.07.2026**
(21) Application number: 25804968.3
(22) Date of filing: 11.03.2025
(51) Int. Cl.: H02J 3/28

(54) **ENERGY STORAGE CONTROL METHOD AND ENERGY STORAGE SYSTEM**

(30) Priority: 20.11.2024 CN 202411665760
(71) Applicant: CSI Energy Storage Co., Ltd., Suzhou Jiangsu 215000 (CN)
(72) Inventor: HUANG, Guijiang, Suzhou Jiangsu 215000 (CN); GUAN, Shuai, Suzhou Jiangsu 215000 (CN); CHA, Ziyao, Suzhou Jiangsu 215000 (CN); YAO, Meiqi, Suzhou Jiangsu 215000 (CN); GAO, Lijun, Suzhou Jiangsu 215000 (CN)
(74) Representative: karo IP
(86) International application number: PCT/CN2025/081860
(87) International publication number: WO 2026/108028

(57) **Abstract**

The present disclosure discloses an energy storage control method and an energy storage system. The energy storage control method includes: determining that an energy storage system is powered on and is operating, and obtaining an online number of energy storage cabinets in the energy storage system, a target total active power of the energy storage system, a State of Health (SOH) value of each energy storage cabinet, and a State of Charge (SOC) value of each energy storage cabinet; obtaining an average SOH value based on the online number and the SOH value, obtaining a first difference value between the SOH value and the average SOH value, obtaining an average SOC value based on the online number and the SOC value and obtaining a second difference value between the SOC value and the average SOC value; and calculating a target power value of each energy storage cabinet based on the target total active power, the online number, an average power value, the first difference value, the second difference value, a preset SOH threshold, a preset SOC threshold, and a preset distribution coefficient.

## Description

### CROSS-REFERENCE TO RELATED APPLICATIONS

The present application claims priority to Chinese Patent Application No. 202411665760.4 filed with the China National Intellectual Property Administration on November 20, 2024 and entitled "ENERGY STORAGE CONTROL METHOD AND ENERGY STORAGE SYSTEM", which is incorporated herein by reference in its entirety.

### TECHNICAL FIELD

The present disclosure relates to the technical field of energy storage, and more particularly, to an energy storage control method and an energy storage system.

### BACKGROUND

To enhance the capacity and reliability of an energy storage system, an outdoor integrated cabinet energy storage system in industrial and commercial applications typically employs an application strategy in which multiple units are connected in parallel. However, in the related art, control strategies for multi-unit parallel application in the energy storage system are mostly relatively simple and lack standardized approaches, The existing control strategies can not be flexibly applied. Additionally, as operating time increases and subsequent system expansion requirements arise, differences in the State of Health (SOH) among individual energy storage cabinets within the system will emerge, and these differences will increase over time. When these differences reach a certain level, they can severely impact the online performance of the system.

### SUMMARY

The present disclosure aims to resolve at least one of the technical problems existing in the related art. Therefore, one aim of the present disclosure is to provide an energy storage control method which is compliance with power distribution requirements for energy storage systems configured with a plurality energy storage cabinets. This method is flexible in application and highly adaptable. Long-term operation can effectively improve the consistency of the State of Health (SOH) across all energy storage cabinets, thereby enhancing the online performance of the energy storage system.

A second aim of the present disclosure is to provide an energy storage system.

To achieve the above aims, an embodiment of a first aspect of the present disclosure provides an energy storage control method. The energy storage control method includes: determining that an energy storage system is powered on and is operating, and obtaining an online number of energy storage cabinets in the energy storage system, a target total active power of the energy storage system, a State of Health (SOH) value of each energy storage cabinet, and a State of Charge (SOC) value of each energy storage cabinet; obtaining an average SOH value based on the online number and the SOH value, obtaining a first difference value between the SOH value and the average SOH value, obtaining an average SOC value based on the online number and the SOC value and obtaining a second difference value between the SOC value and the average SOC value; and calculating a target power value of each energy storage cabinet based on the target total active power, the online number, an average power value, the first difference value, the second difference value, a preset SOH threshold, a preset SOC threshold, and a preset distribution coefficient.

In the energy storage control method according to the embodiment of the present disclosure, the target power value of each energy storage cabinet is calculated by obtaining the online number of energy storage cabinets in the energy storage system, the target total active power of the energy storage system, the SOH value of each energy storage cabinet, the SOC value of each energy storage cabinet and the first difference value between the SOH value and the average SOH value, the average SOC value, the SOC value and the second difference value between the SOC value and the average SOC value. By adopting a power distribution strategy based on the SOHs and SOCs of the energy storage cabinets, the method enables rational distribution of the target power value for each energy storage cabinet. Long-term operation can effectively improve the consistency of the SOH among the various energy storage cabinets, meeting the power distribution requirements of an energy storage system configured with multiple energy storage cabinets. The method offers flexible application and strong adaptability. Furthermore, by accurately calculating the target power value for each energy storage cabinet, power regulation of the energy storage system is achieved, the service life of the energy storage cabinets is extended, and consequently the online performance of the energy storage system is enhanced.

In some embodiments of the present disclosure, the preset SOH threshold includes a first SOH threshold and a second SOH threshold, and the first SOH threshold is less than the second SOH threshold. The preset distribution coefficient includes a first SOH distribution coefficient and a second SOH distribution coefficient, and the first SOH distribution coefficient is greater than the second SOH distribution coefficient.

In some embodiments of the present disclosure, the calculating the target power value of each energy storage cabinet based on the target total active power, the online number, the average power value, the first difference value, the second difference value, the preset SOH threshold, the preset SOC threshold, and the preset distribution coefficient includes: determining that an absolute value of the second difference value of the energy storage cabinet is less than or equal to the preset SOC threshold; and calculating the target power value of each energy storage cabinet based on the target total active power, the online number, the average power value, the first difference value, the first SOH threshold, the second SOH threshold, the first SOH distribution coefficient and the second SOH distribution coefficient.

In some embodiments of the present disclosure, the calculating the target power value of each energy storage cabinet based on the target total active power, the online number, the average power value, the first difference value, the first SOH threshold, the second SOH threshold, the first SOH distribution coefficient and the second SOH distribution coefficient includes: determining that an absolute value of the first difference value of the energy storage cabinet is greater than the second SOH threshold and determining a first target power value P1 of the energy storage cabinet to satisfy P1=Paverage* (1+ΔS0Hx*K1), where Paverage is the average power value, ΔS0Hx is the first difference value of an x-th energy storage cabinet and K1 is the first SOH distribution coefficient; or determining that the absolute value of the first difference value of the energy storage cabinet is greater than the first SOH threshold and is less than or equal to the second SOH threshold and determining a second target power value P2 of the energy storage cabinet to satisfy P2=Paverage*(1+ΔSOHx*K2), where K2 is the second SOH distribution coefficient; or determining that the absolute value of the first difference value of the energy storage cabinet is less than or equal to the first SOH threshold, obtaining a residual target active power value based on the target total active power, all the first target power values and all the second target power values, and performing, based on the residual target active power value, power average distribution to the energy storage cabinets satisfying that the absolute value of the first difference value is less than or equal to the first SOH threshold.

In some embodiments of the present disclosure, the preset distribution coefficient further includes a preset SOC distribution coefficient. The calculating the target power value of each energy storage cabinet based on the target total active power, the online number, the average power value, the first difference value, the second difference value, the preset SOH threshold, the preset SOC threshold, and the preset distribution coefficient further includes: determining that the absolute value of the second difference value of the energy storage cabinet is greater than the preset SOC threshold; and calculating the target power value of each energy storage cabinet based on the target total active power, the online number, the average power value, the first difference value, the second difference value, the first SOH threshold, the second SOH threshold, the first SOH distribution coefficient, the second SOH distribution coefficient and the preset SOC distribution coefficient.

In some embodiments of the present disclosure, the calculating the target power value of each energy storage cabinet based on the target total active power, the online number, the average power value, the first difference value, the second difference value, the first SOH threshold, the second SOH threshold, the first SOH distribution coefficient, the second SOH distribution coefficient and the preset SOC distribution coefficient includes: determining that the absolute value of the first difference value of the energy storage cabinet is greater than the second SOH threshold and determining a third target power value P3 of the energy storage cabinet to satisfy P3=Paverage* (1+ΔSOHx*K1+ΔSOCx*f), where Paverage is the average power value, ΔSOHx is the first difference value of an x-th energy storage cabinet, ΔSOCx is the second difference value of the x-th energy storage cabinet, K1 is the first SOH distribution coefficient and f is the preset SOC distribution coefficient; or determining that the absolute value of the first difference value of the energy storage cabinet is greater than the first SOH threshold and is less than or equal to the second SOH threshold and determining a fourth target power value P4 of the energy storage cabinet to satisfy P4=Paverage* (1+ΔSOHx*K2+ΔSOCx*f), where K2 is the second SOH distribution coefficient; or determining that the absolute value of the first difference value of the energy storage cabinet is less than or equal to the first SOH threshold and determining a fifth target power value P5 of the energy storage cabinet to satisfy P5=Paverage* (1+ΔSOCx*f).

In some embodiments of the present disclosure, the preset distribution coefficient further includes a hysteresis value of a preset SOH power adjustment and a hysteresis value of a preset SOC power adjustment. The method further includes: obtaining a third difference value between the first SOH threshold and the hysteresis value of the preset SOH power adjustment, a fourth difference value between the second SOH threshold and the hysteresis value of the preset SOH power adjustment, and a fifth difference value between the preset SOC threshold and the hysteresis value of the preset SOC power adjustment.

In some embodiments of the present disclosure, the energy storage control method further includes: determining that an operating duration of the energy storage system reaches a preset time threshold and reacquiring the first difference value and the second difference value of the energy storage cabinet; and adjusting the target power value of the energy storage cabinet based on the first difference value, the third difference value and/or the fourth difference value, or adjusting the target power value of the energy storage cabinet based on the second difference value and the fifth difference value.

To achieve the above aims, an energy storage system according to an embodiment in a second aspect of the present disclosure is proposed and includes: a transformer mounted on an alternating current busbar; a gateway electricity meter connected to the alternating current busbar; a master energy storage cabinet connected to both the alternating current busbar and the gateway electricity meter, the master energy storage cabinet being configured to perform the energy storage control method according to any one of the above embodiments; and at least one slave energy storage cabinet connected to the alternating current busbar, the gateway electricity meter and the master energy storage cabinet.

The energy storage system proposed according to the embodiment of the present disclosure includes one master energy storage cabinet and at least one slave energy storage cabinet. By performing the energy storage control method described in the above embodiments, the master energy storage cabinet can precisely calculate and obtain the target power values for both the master energy storage cabinet and at least one slave energy storage cabinet, and thus the system enables rational distribution of the target power value for each energy storage cabinet. Long-term operation can effectively improve the consistency of the SOH among the various energy storage cabinets, meeting the power distribution requirements of an energy storage system configured with multiple energy storage cabinets. The system offers flexible application and strong adaptability. Furthermore, power regulation of the entire energy storage system can be achieved, the service life of each energy storage cabinet can be extended, and consequently the online performance of the energy storage system can be enhanced.

In the embodiments of the present disclosure, when the master energy storage cabinet is determined as being offline, at least one slave energy storage cabinet serves as a new master energy storage cabinet.

The additional aspects and advantages of the present disclosure will be partially presented in the following description, partially become apparent from the description below, or be understood through the practice of the present disclosure.

### BRIEF DESCRIPTION OF THE DRAWINGS

The above and/or other additional aspects and advantages of the present disclosure become apparent and comprehensible from the description of embodiments in connection with accompanying drawings, in which:
FIG. 1 is a schematic diagram of an energy storage system according to an embodiment of the present disclosure;
FIG. 2 is a flow chart of an energy storage control method according to an embodiment of the present disclosure;
FIG. 3 is a flow chart of an energy storage control method according to another embodiment of the present disclosure;
FIG. 4 is a flow chart of an energy storage control method according to yet another embodiment of the present disclosure..

Reference numerals:
energy storage system 1;
transformer 10; gateway electricity meter 20; master energy storage cabinet 30; slave energy storage cabinet 40; AC busbar 50.

### DETAILED DESCRIPTION

Embodiments of the present disclosure will be described below in details. The embodiments described with reference to the accompanying drawings are exemplary.

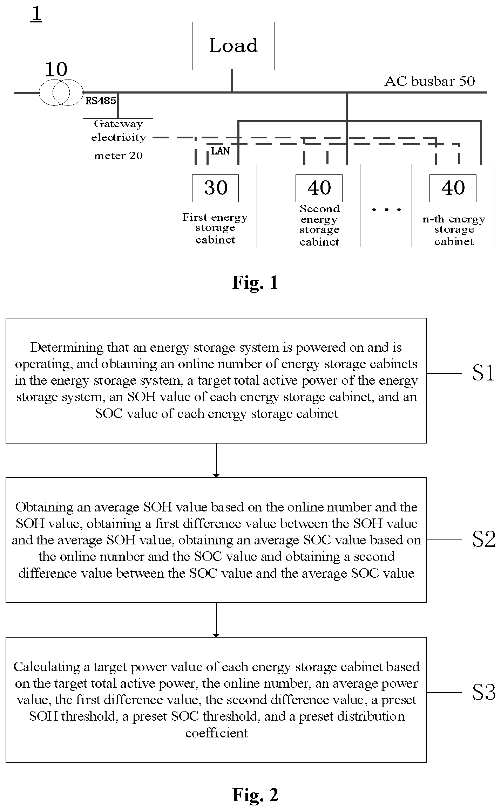

In some embodiments of the present disclosure, an energy storage control method is proposed and is applied to an energy storage system. The structure and functions of various components of the energy storage system 1 according to an embodiment of the present disclosure will first be described below with reference to FIG. 1. FIG. 1 is a schematic diagram of an energy storage system 1 according to an embodiment of the present disclosure. The energy storage system 1 includes a transformer 10, a gateway electricity meter 20, a master energy storage cabinet 30 and at least one slave energy storage cabinet 40. The transformer 10 is disposed in an alternating current (AC) busbar 50. The gateway electricity meter 20 is connected to the AC busbar 50. The master energy storage cabinet 30 is connected to the AC busbar 50 and the gateway electricity meter 20 separately. The master energy storage cabinet 30 is configured to perform the energy storage control method of the embodiments of the present disclosure. The at least one slave energy storage cabinet 40 is connected to the AC busbar 50, the gateway electricity meter 20 and the master energy storage cabinet 30.

Specifically, the master energy storage cabinet 30 and the slave energy storage cabinet 40 are energy storage cabinets with the same specification, with the master energy storage cabinet 30 providing control over the slave energy storage cabinet 40. The AC sides of multiple energy storage cabinets are connected to the AC busbar 50. The gateway electricity meter 20 is mounted on a low-voltage side of the transformer 10 and at a front end of a load. The gateway electricity meter 20 can be connected to the master energy storage cabinet 30 and the slave energy storage cabinet 40 via RS485, and is mainly configured to monitor the electricity consumption in the factory area. The master energy storage cabinet 30 periodically reads the power data from the gateway electricity meter 20. It can be understood that at any given time, only the master energy storage cabinet 30 communicates with the gateway electricity meter 20, while the communication function between the slave energy storage cabinet 40 and the gateway electricity meter 20 is disabled. A charging power of the energy storage system 1 will be limited when a power at the gateway electricity meter 20 becomes excessively high, and a discharging power of the energy storage system 1 will be limited when a power of the gateway electricity meter 20 approaches 0 kW, so as to achieve a charging and discharging protection for the energy storage system 1. The master energy storage cabinet 30 and the slave energy storage cabinet 40 are connected to the same network segment via a network switch, thereby enabling data interaction. The master energy storage cabinet 30 can periodically count the number of online slave energy storage cabinets 40. That is, when the operating duration of the energy storage system 1 reaches a certain time duration, the master energy storage cabinet 30 can reacquire the number of online slave energy storage cabinets 40. Therefore, the energy storage control method of the present disclosure can meet the needs of subsequent expansion of the energy storage system 1.

In some embodiments of the present disclosure, when the master energy storage cabinet 30 is determined to be offline, one slave energy storage cabinet 40 is selected from the plurality of slave energy storage cabinets 40 to serve as a new master energy storage cabinet 30, thereby enabling the implementation of the energy storage control method described in the following embodiments..

Specifically, the adoption of one-master and multi-slaves control architecture can enhance the rationality of power distribution and facilitate user operation. When operating in a master-slave mode, if the master energy storage cabinet 30 experiences an abnormality, the entire energy storage system 1 will cease operation, thereby impacting revenue. To address the issue in the one-master and multi-slaves architecture where an abnormal master energy storage cabinet 30 causes a full system shutdown and affects customer revenue, a master-slave adaptive adjustment technology can be employed. When the master energy storage cabinet 30 is determined to be offline, at least one slave energy storage cabinet 40 serves as a new master energy storage cabinet 30, identifies and performs tasks of the master energy storage cabinet 30, removes the abnormal energy storage cabinet from an operational array, and allows the remaining energy storage cabinets to continue operating as scheduled, thereby improving online rate of the energy storage system 1.

Moreover, during normal operation of the energy storage system 1, it is only necessary to configure the overall planned power curve on the master energy storage cabinet 30. The master energy storage cabinet 30 will then transmit the relevant settings to each slave energy storage cabinet 40 for backup. Simultaneously, the master energy storage cabinet 30 determines the number of online energy storage cabinets within the energy storage system 1 and allocates the total power to each online energy storage cabinet. The specific implementation strategy is as follows.

The energy storage control method according to the embodiments of the present disclosure is described below with reference to FIGS. 2 to 4.

FIG. 2 is a flow chart of an energy storage control method according to an embodiment of the present disclosure. The energy storage control method at least includes step S1 to S3, the details are as follows.

At step S1, it is determined that an energy storage system is powered on and is operating, and an online number of energy storage cabinets in the energy storage system, a target total active power of the energy storage system, a State of Health (SOH) value of each energy storage cabinet, and a State of Charge (SOC) value of each energy storage cabinet are obtained.

Specifically, an energy storage system including n energy storage cabinets is taken as an example. SOH1 represents an SOH value of a first energy storage cabinet, SOH2 represents an SOH value of a second energy storage cabinet 2, and SOHn represents an SOH value of an n-th energy storage cabinet. SOC1 represents an SOC value of a first energy storage cabinet 1, SOC2 represents an SOC value of a second energy storage cabinet, and SOCn represents an SOC value of an n-th energy storage cabinet.

At step S2, an average SOH value is obtained based on the online number and the SOH value, a first difference value between the SOH value and the average SOH value is obtained, an average SOC value is obtained based on the online number and the SOC value and a second difference value between the SOC value and the average SOC value is obtained.

For example, SOHsum represents a sum of the SOH values of all currently online energy storage cabinets. It is assumed that the energy storage system at this time includes a first energy storage cabinet, a second energy storage cabinet, ..., an n-th energy storage cabinet and all n energy storage cabinets are online, then SOHsum=SOH1+SOH2+•••+SOHn. Furthermore, the average SOH value can be expressed as SOHaverage and SOHaverage is equal to a value obtained by dividing SOHsum by the online number of the energy storage cabinets. ΔSOHx represents a first difference value of the xth energy storage cabinet, which is ΔSOH of the x-th energy storage cabinet. For example, ΔSOH1 is the first difference value of the first energy storage cabinet, Δ SOH2 is the first difference value of the second energy storage cabinet, •••, ΔSOHn is the first difference value of the n-th energy storage cabinet.

Similarly, SOCsum represents a sum of the SOC values of all currently online energy storage cabinets. It is assumed that the energy storage system at this time includes a first energy storage cabinet, a second energy storage cabinet, ..., an n-th energy storage cabinet and all n energy storage cabinets are online, then SOCsum=SOC1+SOC2+•••+SOCn. Furthermore, an average SOC value can be expressed as SOCaverage and SOCaverage is equal to a value obtained by dividing the SOCsum by the online number of the energy storage cabinets. ΔSOCx represents a second difference value of the x-th energy storage cabinet, which is ΔSOC of the x-th energy storage cabinet. For example, ΔSOC1 is the second difference value of the first energy storage cabinet, ΔSOC2 is the second difference value of the second energy storage cabinet, •••, ΔSOCn is the second difference value of the n-th energy storage cabinet.

At step S3, a target power value of each energy storage cabinet is calculated based on the target total active power, the online number, an average power value, the first difference value, the second difference value, a preset SOH threshold, a preset SOC threshold, and a preset distribution coefficient.

According to the energy storage control method of the embodiment of the present disclosure, the target power value of each energy storage cabinet is calculated by obtaining data information such as the online number of energy storage cabinets in the energy storage system, the target total active power of the energy storage system, the SOH value of each energy storage cabinet, the SOC value of each energy storage cabinet, the first difference value between the SOH value and the average SOH value, the average SOC value, the second difference value between the SOC value and the average SOC value. By adopting a power distribution strategy based on the SOHs and SOCs of the energy storage cabinets, the method enables rational distribution of the target power value for each energy storage cabinet. Long-term operation can effectively improve the consistency of the SOH among the various energy storage cabinets, meeting the power distribution requirements of an energy storage system configured with multiple energy storage cabinets. The method offers flexible application and strong adaptability. Furthermore, by accurately calculating the target power value for each energy storage cabinet, power regulation of the energy storage system is achieved, the service life of the energy storage cabinets is extended, and consequently the online performance of the energy storage system is enhanced.

Based on the above, according to the energy storage system of the embodiment of the present disclosure, the energy storage system includes one master energy storage cabinet 30 and at least one slave energy storage cabinet 40. The master energy storage cabinet 30 can precisely calculate the target power value of the master energy storage cabinet 30 and the at least one slave energy storage cabinet 40 by performing the energy storage control method of the above embodiment of the present disclosure, and thereby achieving rational distribution of the target power value for each energy storage cabinet. Long-term operation can effectively improve the consistency of the SOH among the various energy storage cabinets, meeting the power distribution requirements of an energy storage system configured with multiple energy storage cabinets. The method offers flexible application and strong adaptability. Furthermore, power regulation of the energy storage system can be achieved, the service life of the energy storage cabinets can be extended, and consequently the online performance of the energy storage system can be enhanced.

In some embodiments of the present disclosure, the preset SOH threshold includes a first SOH threshold and a second SOH threshold. The first SOH threshold is less than the second SOH threshold. A preset distribution coefficient includes a first SOH distribution coefficient and a second SOH distribution coefficient. The first SOH distribution coefficient is greater than the second SOH distribution coefficient.

Specifically, SOH _tha represents the preset SOH threshold, and SOH_tha>0. According to calculation, the number of preset SOH thresholds that need to be set and a magnitude relationship between them can be controlled. For example, a can be 1, 2, 3..., and can represents respectively SOH_th1, SOH_th2, SOH_th3...and SOH _th1<SOH_th2<SOH_th3....

In some embodiments of the present disclosure, SOH_tha can be set to include SOH_th1 and SOH_th2. SOH_th1 is the first SOH threshold. SOH_th2 is the second SOH threshold and the first SOH threshold is less than the second SOH threshold.

Furthermore, SOC_thb represents the preset SOC threshold. b can be 1, 2, 3..., and can represents respectively SOC_th1, SOC_th2, SOC_th3...and SOC_th1 < SOC_th2 < SOC_th3.... In some embodiments of the present disclosure, SOC_thb can be set to include SOC_th1, where SOC_th1 is the first SOC threshold.

Furthermore, the preset distribution coefficient includes a power distribution coefficient based on the SOH. The power distribution coefficient based on the SOH is expressed as K, where K>0. The power distribution coefficient based on the SOH may include a first SOH distribution coefficient K1 and a second SOH distribution coefficient K2, where K1 is greater than K2. K1 and K2 can be set according to requirements, and are not specifically defined herein.

In an embodiment of the present disclosure, an example in which the preset SOH threshold includes the first SOH threshold and the second SOH threshold, and the preset SOC threshold includes the first SOC threshold is described. The first SOH threshold is SOH_th1 and the second SOH threshold is SOH_th2, where SOH_th1<SOH_th2. The preset SOC threshold is SOC_th1. In a specific application, an actual online power of each energy storage cabinet needs to be taken into account to limit power distribution. Consequently, specific values for SOH _th1, SOH_th2, and SOC_th1 need to be defined for power distribution. For example, SOH_th1 can be set to 3%-5%, SOH_th2 can be set to 5%-8% and SOC_th1 can be set to 5%-10%.

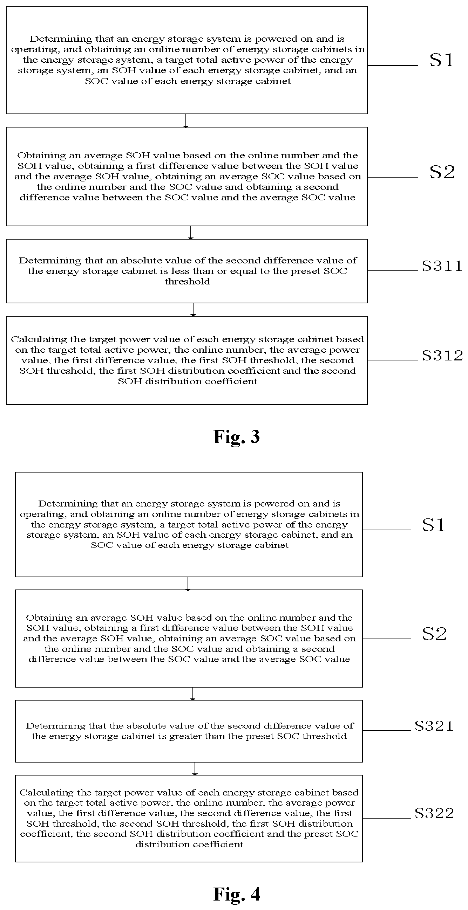

In some embodiments, as shown in FIG.3 which is a flow chart of an energy storage control method according to another embodiment of the present disclosure, the target power value of each energy storage cabinet is calculated based on the target total active power, the online number, the average power value, the first difference value, the second difference value, the preset SOH threshold, the preset SOC threshold, and the preset distribution coefficient. That is, step S3 as described above may specifically include steps S311 and S312.

At step S311, it is determined that an absolute value of the second difference value of the energy storage cabinet is less than or equal to the preset SOC threshold.

Specifically, |ΔSOCx| represents an absolute value of the second difference value between the SOC value of the x-th energy storage cabinet and the average SOC value, that is the absolute value of the second difference value. When the second difference value of any energy storage cabinet satisfies |ΔSOCx| ≤ SOC_th1, step S312 can be executed.

It should be noted that the energy storage control method proposed in the embodiments of the present disclosure is actually a power distribution strategy based on SOH and SOC. Under normal conditions, a power distribution value is typically adjusted first based on a range of ΔSOHx , thereby performing an initial power distribution, and then power re-distribution is performed based on the SOC. However, it can be understood that when the energy storage system is powered on for the first time and operates, all energy storage cabinets are in a fully charged state, and the initial SOC of each energy storage cabinet is 100%. Therefore, the power distribution value can first be adjusted based on a range of ΔSOHx for the energy storage cabinet. That is, the following control method which primarily adjusting the power distribution value based on the range of ΔSOHx of the energy storage cabinet is actually carried out under the condition that the absolute value of the second difference value of the energy storage cabinet is less than or equal to the preset SOC threshold.

At step S312, the target power value of each energy storage cabinet is calculated based on the target total active power, the online number, the average power value, the first difference value, the first SOH threshold, the second SOH threshold, the first SOH distribution coefficient and the second SOH distribution coefficient.

Specifically, calculating the target power value of each energy storage cabinet based on the target total active power, the online number, the average power value, the first difference value, the first SOH threshold, the second SOH threshold, the first SOH distribution coefficient and the second SOH distribution coefficient includes the following three situations: an absolute value of the first difference value in the energy storage cabinet being greater than the second SOH threshold; the absolute value of the first difference value of the energy storage cabinet being greater than the first SOH threshold and being less than or equal to the second SOH threshold; and the absolute value of the first difference value of the energy storage cabinet being less than or equal to the first SOH threshold. |ΔSOHx| represents an absolute value of a difference value between the SOH value of an x-th energy storage cabinet and the average SOH value, that is the absolute value of the first difference value.

The following description is provided on the premise that the second difference value of each energy storage cabinet satisfies |ΔSOCx| ≤ SOC_th1.

Specifically, when the ΔSOH of each of all the online energy storage cabinets satisfies |ΔSOHx| ≤ SOH_th2, power distribution is carried out according to the following distribution method as follows. Specifically, the relationship between |ΔSOHx| and SOH_th1 is further determined. If the |ΔSOHx| of each of all energy storage cabinets satisfies |ΔSOHx| ≤ SOH_th1, which indicates that the SOH differences among the energy storage cabinets are not significant, then the power of each energy storage cabinet is controlled to operate at the average power Paverage.

Alternatively, when it is determined that the absolute value of the first difference value of the energy storage cabinet is greater than the first SOH threshold and is less than or equal to the second SOH threshold, the second target power value P2 of the energy storage cabinet satisfies P2=Paverage*<(1+ΔSOHx*K2), where K2 is the second SOH distribution coefficient. That is, if there is at least one storage cabinet satisfying SOH _th1<|ΔSOHx|≤SOH_th2, it indicates that SOH of one or more energy storage cabinets is significantly different from those of others. For the storage cabinet satisfying SOH_th1<|ΔSOHx|≤SOH_th2, its operating power is controlled according to the calculation method P2=Paverage*(1+ΔSOHx*K2) for the second target power value.

Alternatively, when it is determined that the absolute value of the first difference value of the energy storage cabinet is less than or equal to the first SOH threshold, a residual target active power value is obtained based on the target total active power, all the first target power values and all the second target power values, and power average distribution is performed on the energy storage cabinets satisfying that the absolute value of the first difference value is less than or equal to the first SOH threshold based on the residual target active power value. That is, for a situation that at least one storage cabinet satisfying SOH_th1<|ΔSOHx|≤SOH≤_th2 is present, for other online storage cabinets, |ΔSOHx| of each of which satisfies |ΔSOHx|≤SOH_th1, equal power distribution is performed based on a residual distributable power.

Alternatively, when it is determined that the absolute value of the first difference value of the energy storage cabinet is greater than the second SOH threshold, it is necessary to adjust the power of the relevant energy storage cabinet based on SOC difference. When the second difference value for each of all the energy storage cabinets in the present embodiment satisfies |Δ SOCx|≤SOC_th1, the first target power value P1 of each of the energy storage cabinet satisfies P1=Paverage* (1+ΔSOHx*K1). That is, when there is at least one online energy storage cabinet, ΔSOH of wihch satisfies |ΔSOHx|>SOH_th2, it represents that SOH of this energy storage cabinet differs significantly from SOH of other energy storage cabinets, and operating power of this energy storage cabinet is controlled according to a calculation method for the first target power value: P1=Paverage*(1+ΔSOHx*K2). Additionaly in a case that there is at least one online energy storage cabinet, ΔSOH of which satisfies |ΔSOHx|>SOH_th2, in other online energy storage cabinets, if the energy storage cabinet satisfying SOH_th1< |ΔSOHx| ≤SOH_th2 is present, the target power value for the corresponding energy storage cabinet is calculated using the calculation method of the second target power value P2=Paverage*(1+ΔSOHx*K2) in the above embodiment. In addition, in the other online energy storage cabinets, if the energy storage cabinet, ΔSOH of which satisfies |ΔSOHx|≤SOH_th2, is present, average distribution is performed based on the residual available power for such an energy storage cabinet.

In some other embodiments of the present disclosure, the preset distribution coefficient further includes a preset SOC distribution coefficient. The preset distribution coefficient includes a power distribution coefficient based on SOC. The power distribution coefficient based on SOC is represented as f, where f > 0. The power distribution coefficient based on SOC may include a preset SOC distribution coefficient f. The f can be set according to requirements, and is not specifically limited herein.

As shown in FIG.4 which is a flow chart of an energy storage control method according to yet another embodiment of the present disclosure. Step S3 as described above may further include step S321 and step S322.

At step S321, it is determined that the absolute value of the second difference value of the energy storage cabinet is greater than the preset SOC threshold.

If it is determined that the absolute value of the first difference value of the energy storage cabinet is lager than the second SOH threshold, that is if there exists at least one online energy storage cabinet whose ΔSOH satisfies |ΔSOHxl>SOH_th2 and thus it is necessary to perform power adjustment for the relevant energy storage cabinet based on the SOC difference, it is determined that there is a situation in which the absolute value of the second difference value of at least one energy storage cabinet is greater than the preset SOC threshold. The following description is provided based on this situation as a precondition..

At step S322, the target power value of each energy storage cabinet is calculated based on the target total active power, the online number, the average power value, the first difference value, the second difference value, the first SOH threshold, the second SOH threshold, the first SOH distribution coefficient, the second SOH distribution coefficient and the preset SOC distribution coefficient.

Specifically, under the condition that the aforementioned precondition is met, the first difference values of all online energy storage cabinets may have the following three situations: the absolute value of the first difference value of the energy storage cabinet is greater than the second SOH threshold; or the absolute value of the first difference value of the energy storage cabinet is greater than the first SOH threshold and is less than or equal to the second SOH threshold; or the absolute value of the first difference value of the energy storage cabinet is less than or equal to the first SOH threshold.

The following description is provided on the premise that there exists at least one online energy storage cabinet whose ΔSOH satisfies |ΔSOHx|>SOH_th2, and that there exists at least one energy storage cabinet whose second difference value has an absolute value greater than the preset SOC threshold.

In some embodiments of the present disclosure, when it is determined that the absolute value of the first difference value of the online energy storage cabinet is greater than the second SOH threshold, a third target power value P3 of the energy storage cabinet satisfies P3=Paverage* (1+ΔSOHx*K1+ΔSOCx*f), where Paverage is the average power value, ΔSOHx is the first difference value of an x-th energy storage cabinet, ΔSOCx is the second difference value of the x-th energy storage cabinet, K1 is the first SOH distribution coefficient and f is the preset SOC distribution coefficient. Alternatively, when it is determined that the absolute value of the first difference value of the energy storage cabinet is greater than the first SOH threshold and is less than or equal to the second SOH threshold, a fourth target power value P4 of the energy storage cabinet satisfies P4=Paverage* (1+ΔSOHx*K2+ΔSOCx*f), where K2 is the second SOH distribution coefficient. Alternatively, when it is determined that the absolute value of the first difference value of the energy storage cabinet is less than or equal to the first SOH threshold, a fifth target power value P5 of the energy storage cabinet satisfies P5=Paverage* (1+ΔSOCx*f) .

Based on the above, it can be seen that calculation of the target power value for each energy storage cabinet in the energy storage system is performed not only based on SOH differences, but also based on the SOC differences to adjust the power of the relevant energy storage cabinets. Power distribution based on SOH can gradually improve the SOH consistency of the energy storage system through long-term operation, and the power redistribution based on SOC is to meet a current total power demand.

In some embodiments of the present disclosure, the preset distribution coefficient further includes a hysteresis value of a preset SOH power adjustment and a hysteresis value of a preset SOC power adjustment. A third difference value between the first SOH threshold and the hysteresis value of the preset SOH power adjustment, a fourth difference value between the second SOH threshold and the hysteresis value of the preset SOH power adjustment, and a fifth difference value between the preset SOC threshold and the hysteresis value of the preset SOC power adjustment are obtained.

The hysteresis value of the preset SOH power adjustment can be represented as SOH_thdiff. The hysteresis value of the preset SOC power adjustment can be represented as SOC_thdiff. For example, SOC_thdiff can be set to 2%-3%. SOH _thdiff can be set to 1%-2%. The third difference value can be expressed as SOH_th1 - SOH_thdif. The fourth difference value can be expressed as SOH _th2 - SOH_thdif. The fifth difference value can be expressed as SOC_th1 - SOC_thdif.

Specifically, in practical applications, if there is no the hysteresis value of the preset SOH power adjustment or the hysteresis value of the preset SOC power adjustment, the following scenarios may occur as follows. For an energy storage cabinet satisfying SOH_th1 <|Δ SOH|≤SOH_th2, when a situation in which the ΔSOH of the energy storage cabinet satisfies |Δ SOH| < SOH_th1 arises, the energy storage system will adjust the target power threshold of the energy storage cabinet. For an energy storage cabinet satisfying SOH_th2 < |ΔSOH|, when a situation in which the ΔSOH of the energy storage cabinet satisfies SOH_th1 <|ΔSOH|≤ SOH_th2 arises, the energy storage system will adjust the target power threshold of the energy storage cabinet. For an energy storage cabinet satisfying SOC_th1 ≤|ΔSOC|, when a situation in which the |ΔSOC| of the energy storage cabinet satisfies |ΔSOC|<SOC_th1 arises, the energy storage system will adjust the target power threshold of the energy storage cabinet. It can be understood that during the actual operation of the energy storage cabinet, the |ΔSOH| and |ΔSOC| of each energy storage cabinet change in real time. Since all the above three situations may occur frequently, frequent switching of target power values for various energy storage cabinets is required. As a result, the computational load of the entire system is increased and control costs of the energy storage system are increased. Based on this, the embodiments of the present disclosure propose the hysteresis value SOH _thdiff of the preset SOH power adjustment and the hysteresis value SOC_thdiff of the preset SOC power adjustment, to correspond to real-time variations of |SOH| and |SOC| in the energy storage cabinet.

In some embodiments of the present disclosure, when it is determined that an operating duration of the energy storage system reaches a preset time threshold, the first difference value and the second difference value of the energy storage cabinet are reacquired. The target power value of the energy storage cabinet is adjusted based on the first difference value, the third difference value and/or the fourth difference value, or the target power value of the energy storage cabinet is adjusted based on the second difference value and the fifth difference value. It can be understood that the preset time threshold can be set as needed and is not limited here. For example, the preset time threshold can be set to a very short duration to enable real-time monitoring of operational status of each energy storage cabinet. Or the preset time threshold can be set to 3 minutes, 5 minutes, 10 minutes, etc for periodic inspection and adjustment of the operational status of each energy storage cabinet.

Specifically, after a period of operation, differences in the SOH values of the energy storage cabinets may increase and SOC values of the energy storage cabinets may change. Therefore, when the operating duration of the energy storage system reaches a preset time threshold, the embodiment of the present disclosure will reacquire the first difference value and the second difference value of the energy storage cabinet and then adjust the target power value of the energy storage cabinet based on the first difference value, the third difference value and/or the fourth difference value or adjust the target power value of the energy storage cabinet based on the second difference value and the fifth difference value.

Specifically, for an energy storage cabinet satisfying SOH_th1 <|ΔSOH|≤ SOH_th2, the target power value of the energy storage cabinet will only be adjusted when |ΔSOH| of the energy storage cabinet satisfies |ΔSOH| < SOH_th1 - SOH_thdiff. Alternatively, for an energy storage cabinet satisfying SOH_th2< |ΔSOH|, the target power value of the energy storage cabinet will only be adjusted when |ΔSOH| of the energy storage cabinet satisfies |ΔSOH|< SOH_th2-SOH_thdiff. For an energy storage cabinet satisfying SOC_th1≤|ΔSOC|, the target power value of the energy storage cabinet will only be adjusted when|ΔSOC|of the energy storage cabinet satisfies |ΔSOC|<SOC_th1-SOC_thdiff. By setting the hysteresis value SOH _thdiff of the SOH power adjustment and the hysteresis value SOC_thdiffof the preset SOC power adjustment, it can effectively avoid excessive adjustment of power distribution.

Based on the above, a function of the hysteresis value of the preset SOH power adjustment and the hysteresis value of the preset SOC power adjustment is to control the adjustment frequency, and to prevent overly frequent power distribution. Especially when in a critical state, without hysteresis value judgment, the system would trigger adjustments when values exceed thresholds and revert when values fall below thresholds, resulting in repeated controls. The hysteresis value extends the operating time after each power adjustment.

According to the energy storage control method proposed in the embodiments of the present disclosure, the following uses the parallel operation of five energy storage cabinets in an energy storage system as an example for description.. It is assumed that the target total active power Psum of the energy storage system is 300 kW, the energy storage system is operating in the discharge mode, |ΔSOH4| of the fourth energy storage cabinet satisfies SOH_th1 <|ΔSOH4|< SOH_th2, |ΔSOH5| of the fifth energy storage cabinet satisfies |ΔSOH5|>SOH_th2, other online energy storage cabinets satisfy |ΔSOHx|≤SOH_th1, and the initial SOC of each energy storage cabinet is 100%. The first-stage power distribution is as follows. the target power values for the first to fifth energy storage cabinets are represented as P1, P2, P3, P4, and P5 respectively.

The average power value is Paverage=Psum/n=300KW/5=60KW, P4=60* (1+ ΔSOH4*K2) , P5=60* (1+ΔSOH5*K1) and P1, P2 and P3= (300KW - P4 - P5) /3. When |SOC4| > SOC_th1 of the fourth energy storage cabinet occurs during the operation, the second-stage power distribution is as follows.

Specifically, P4=60* (1+ΔSOH4*K2+ΔSOC4*f) , P5=60* (1+ΔSOH5*K1) and P1, P2 and P3= (300KW - P4 - P5) /3. After a period of operation, when |ΔSOC4|<SOC_th1 -SOC_thdiff is satisfied, all energy storage cabinets resume execution of the first-stage power distribution. When |ΔSOH4|<SOH_th1-SOH_thdiff is satisfied, that is at this point, the SOH difference of the fourth energy storage cabinet has decreased to a reasonable range and indicates that the adjustment has been effectively achieved. The power is distributed equally based on the residual power.

After a period of operation, when the fifth energy storage cabinet satisfies |Δ SOH5|<SOH_th2-SOH_thdiff, the target power value for the fifth energy storage cabinet is adjusted to P5=60* (1+ΔSOH5*K2) . After another period of operation, when the fifth energy storage cabinet satisfies |ΔSOH5|<SOH_th1-SOH_thdiff, the target power value for the fifth energy storage cabinet is distributed equally based on the residual power.

The other components and operation of the energy storage system 1 according to the embodiments of the present disclosure are well known to those skilled in the art and are not described in detail herein.

In the illustration of the present description, a description with reference to the terms "one embodiment," "some embodiments," "exemplary embodiments," "examples," "specific examples," or "some examples," etc. means that a specific feature, structure, material, or characteristic described in connection with the embodiment or example is included in at least one embodiment or example of the present disclosure. In the present description, schematic expressions of the above terms do not necessarily refer to the same embodiments or examples.

Although embodiments of the present disclosure have been shown and described, those of ordinary skill in the art can understand that various changes, modifications, substitutions, and variations can be made to these embodiments without departing from the principles and spirit of the present disclosure. The scope of the present disclosure is defined by the claims and their equivalents.

## Claims

1. An energy storage control method, comprising:
determining that an energy storage system is powered on and is operating, and obtaining an online number of energy storage cabinets in the energy storage system, a target total active power of the energy storage system, a State of Health (SOH) value of each energy storage cabinet, and a State of Charge (SOC) value of each energy storage cabinet;
obtaining an average SOH value based on the online number and the SOH value, obtaining a first difference value between the SOH value and the average SOH value, obtaining an average SOC value based on the online number and the SOC value and obtaining a second difference value between the SOC value and the average SOC value; and
calculating a target power value of each energy storage cabinet based on the target total active power, the online number, an average power value, the first difference value, the second difference value, a preset SOH threshold, a preset SOC threshold, and a preset distribution coefficient.

2. The energy storage control method according to claim 1, wherein,
the preset SOH threshold comprises a first SOH threshold and a second SOH threshold, and the first SOH threshold is less than the second SOH threshold; and
the preset distribution coefficient comprises a first SOH distribution coefficient and a second SOH distribution coefficient, and the first SOH distribution coefficient is greater than the second SOH distribution coefficient.

3. The energy storage control method according to claim 2, wherein said calculating the target power value of each energy storage cabinet based on the target total active power, the online number, the average power value, the first difference value, the second difference value, the preset SOH threshold, the preset SOC threshold, and the preset distribution coefficient comprises:
determining that an absolute value of the second difference value of the energy storage cabinet is less than or equal to the preset SOC threshold; and
calculating the target power value of each energy storage cabinet based on the target total active power, the online number, the average power value, the first difference value, the first SOH threshold, the second SOH threshold, the first SOH distribution coefficient and the second SOH distribution coefficient.

4. The energy storage control method according to claim 3, wherein said calculating the target power value of each energy storage cabinet based on the target total active power, the online number, the average power value, the first difference value, the first SOH threshold, the second SOH threshold, the first SOH distribution coefficient and the second SOH distribution coefficient comprises:
determining that an absolute value of the first difference value of the energy storage cabinet is greater than the second SOH threshold and determining a first target power value P1 of the energy storage cabinet to satisfy P1=Paverage* (1+ΔSOHx*K1), wherein Paverage is the average power value, ΔSOHx is the first difference value of an x-th energy storage cabinet and K1 is the first SOH distribution coefficient; or
determining that the absolute value of the first difference value of the energy storage cabinet is greater than the first SOH threshold and is less than or equal to the second SOH threshold and determining a second target power value P2 of the energy storage cabinet to satisfy P2=Paverage*(1+ΔSOHx*K2), wherein K2 is the second SOH distribution coefficient; or
determining that the absolute value of the first difference value of the energy storage cabinet is less than or equal to the first SOH threshold, obtaining a residual target active power value based on the target total active power, all the first target power values and all the second target power values, and performing, based on the residual target active power value, power average distribution to the energy storage cabinets satisfying that the absolute value of the first difference value is less than or equal to the first SOH threshold.

5. The energy storage control method according to any one of claims 2 to 4, wherein the preset distribution coefficient further comprises a preset SOC distribution coefficient, said calculating the target power value of each energy storage cabinet based on the target total active power, the online number, the average power value, the first difference value, the second difference value, the preset SOH threshold, the preset SOC threshold, and the preset distribution coefficient further comprises:
determining that an absolute value of the second difference value of the energy storage cabinet is greater than the preset SOC threshold; and
calculating the target power value of each energy storage cabinet based on the target total active power, the online number, the average power value, the first difference value, the second difference value, the first SOH threshold, the second SOH threshold, the first SOH distribution coefficient, the second SOH distribution coefficient and the preset SOC distribution coefficient.

6. The energy storage control method according to claim 5, wherein said calculating the target power value of each energy storage cabinet based on the target total active power, the online number, the average power value, the first difference value, the second difference value, the first SOH threshold, the second SOH threshold, the first SOH distribution coefficient, the second SOH distribution coefficient and the preset SOC distribution coefficient comprises:
determining that an absolute value of the first difference value of the energy storage cabinet is greater than the second SOH threshold and determining a third target power value P3 of the energy storage cabinet to satisfy P3=Paverage* (1+ΔSOHx*K1+ΔSOCx*f), wherein Paverage is the average power value, ΔSOHx is the first difference value of an x-th energy storage cabinet, ΔSOCx is the second difference value of the x-th energy storage cabinet, K1 is the first SOH distribution coefficient and f is the preset SOC distribution coefficient; or
determining that the absolute value of the first difference value of the energy storage cabinet is greater than the first SOH threshold and is less than or equal to the second SOH threshold and determining a fourth target power value P4 of the energy storage cabinet to satisfy P4=Paverage* (1+ΔSOHx*K2+ΔSOCx*f), wherein K2 is the second SOH distribution coefficient; or
determining that the absolute value of the first difference value of the energy storage cabinet is less than or equal to the first SOH threshold and determining a fifth target power value P5 of the energy storage cabinet to satisfy P5=Paverage* (1+ΔSOCx*f) .

7. The energy storage control method according to any one of claims 2 to 6, wherein the preset distribution coefficient further comprises a hysteresis value of a preset SOH power adjustment and a hysteresis value of a preset SOC power adjustment, the method further comprises:
obtaining a third difference value between the first SOH threshold and the hysteresis value of the preset SOH power adjustment, a fourth difference value between the second SOH threshold and the hysteresis value of the preset SOH power adjustment, and a fifth difference value between the preset SOC threshold and the hysteresis value of the preset SOC power adjustment.

8. The energy storage control method according to claim 7, further comprising:
determining that an operating duration of the energy storage system reaches a preset time threshold and reacquiring the first difference value and the second difference value of the energy storage cabinet; and
adjusting the target power value of the energy storage cabinet based on the first difference value, the third difference value and/or the fourth difference value, or adjusting the target power value of the energy storage cabinet based on the second difference value and the fifth difference value.

9. An energy storage system (1), comprising:
a transformer (10) mounted on an alternating current (AC) busbar (50);
a gateway electricity meter (20) connected to the AC busbar (50);
a master energy storage cabinet (30) connected to both the AC busbar (50) and the gateway electricity meter (20), the master energy storage cabinet (30) being configured to perform the energy storage control method according to any one of claims 1 to 8; and
at least one slave energy storage cabinet (40) connected to the AC busbar (50), the gateway electricity meter (20) and the master energy storage cabinet (30).

10. The energy storage system (1) according to claim 9, wherein when the master energy storage cabinet (30) is determined as being offline, at least one slave energy storage cabinet (40) serves as a new master energy storage cabinet (30).
